# FASCICULE DE BREVET EUROPEEN

(11) **EP 2 064 563 B1**
(45) Date de publication et mention de la délivrance du brevet: **23.01.2013**
(21) Numéro de dépôt: 07848329.4
(22) Date de dépôt: 18.09.2007
(51) Int. Cl.: G01R 31/36

(54) **DISPOSITIF DE MESURE DE PARAMETRES D'UNE SOURCE D'ALIMENTATION ELECTRIQUE, COMPRENANT UNE HORLOGE**
VORRICHTUNG MIT UHR ZUR MESSUNG DER PARAMETER EINER STROMQUELLE
DEVICE FOR MEASURING THE PARAMETERS OF AN ELECTRIC POWER SOURCE, COMPRISING A CLOCK

(30) Priorité: 21.09.2006 FR 0653852
(43) Date de publication de la demande: 03.06.2009
(73) Titulaire: Valeo Electronique et Systemes de Liaison, 78180 Montigny le Bretonneux (FR)
(72) Inventeur: THIMON, Alain, 93230 Romainville (FR)
(74) Mandataire: de Lambilly Delorme, Marie Pierre
(86) Numéro de dépôt international: PCT/FR2007/051956
(87) Numéro de publication internationale: WO 2008/035004

(56) Documents cités:
- EP-A- 1 164 682
- WO-A-00/67359
- FR-A- 2 874 701
- FR-A- 2 874 702
- US-A- 6 025 695

## Description

La présente invention concerne un dispositif de mesure de paramètres d'une source d'alimentation électrique, comprenant une horloge.

Elle s'applique plus particulièrement à la mesure de paramètres d'une batterie d'un véhicule automobile, par exemple une intensité, une tension ou encore une température.

Dans ce qui suit, on appellera acquisition d'un paramètre, l'acquisition d'une grandeur électrique destinée à définir ce paramètre.

On connaît déjà, dans l'état de la technique, un dispositif de mesure de paramètres, du type comprenant une chaîne d'acquisition et de traitement de données comportant :
- un premier élément d'acquisition d'un premier paramètre, alimenté par une tension définie par une différence entre un potentiel de source d'alimentation électrique et un potentiel supérieur à ce potentiel de source, le potentiel supérieur étant fourni par un premier élément d'alimentation,
- une horloge destinée à cadencer un signal d'activation d'un élément de la chaîne, dit signal d'horloge.

Habituellement, le potentiel de source est la borne positive de la batterie et le potentiel supérieur au potentiel de source est fourni par le premier élément d'alimentation formant élévateur de tension.

Le premier paramètre est par exemple une intensité d'un courant circulant dans un circuit raccordé au potentiel de source, ce premier paramètre étant fourni par un shunt.

Comme le premier élément d'acquisition de l'intensité a pour référence le potentiel de source, il est sensible à de relativement faibles variations de potentiel autour de ce potentiel de source et fournit une mesure relativement précise de l'intensité.

Cette mesure de l'intensité du courant doit être réalisable aussi bien lorsque le moteur du véhicule automobile tourne que lorsque le moteur est à l'arrêt.

En effet, lorsque le moteur est à l'arrêt, certains organes du véhicule automobile sont maintenus en état de veille afin de réaliser des fonctions, par exemple, de réception des signaux de télécommande d'ouverture des portes, d'horloge, et de ce fait doivent être alimentés continûment en courant.

Ainsi, il est souhaitable de réaliser régulièrement des mesures de courant même lorsque le moteur est à l'arrêt afin de détecter une consommation anormale du courant liée, par exemple, à un dysfonctionnement éventuel d'un de ces organes électriques en état de veille.

A cet effet, dans l'état de la technique, l'horloge cadence un signal d'activation du premier élément d'acquisition à la suite duquel le premier élément d'acquisition est susceptible d'adopter un état actif.

Dans son état actif, le premier élément d'acquisition effectue notamment une acquisition d'une différence de potentiel aux bornes du shunt, liée à l'intensité à mesurer. Une fois l'acquisition effectuée, le premier élément d'acquisition est susceptible d'adopter un état de veille dans lequel la consommation de courant est relativement faible.

Or, dans l'état de la technique, l'horloge est alimentée continûment par l'élévateur de tension. Ceci entraîne une consommation relativement importante de courant risquant de provoquer une décharge de la batterie, en particulier lorsque le moteur est à l'arrêt. En effet, la consommation de courant de l'horloge s'ajoute à la consommation de courant du premier élément d'acquisition en état actif ou en état de veille ainsi qu'à la consommation continue de courant de l'élévateur de tension.

Le document US-A-6 025 695 décrit une batterie rechargeable et une méthode de gestion des opérations d'une batterie rechargeable comprenant un capteur permettant de mesurer des paramètres de la batterie et générer un signal analogique fonction de ce paramètre.

Le document FR-A-2 874 702 décrit un dispositif de mesure d'au moins un paramètre de fonctionnement d'une batterie de véhicule automobile et un réseau de transmission de données pour ce véhicule.

L'invention a notamment pour but de proposer un dispositif de mesure ayant une consommation de courant limitée tout en permettant de réaliser des mesures précises de l'intensité du courant.

A cet effet, l'invention a pour objet un dispositif de mesure du type précité, **caractérisé en ce que** l'élément activé par le signal d'horloge est un élément de pilotage des premiers éléments d'alimentation et d'acquisition, susceptible d'adopter un état de veille coïncidant avec un état désactivé du premier élément d'alimentation, et un état actif à la suite de son activation par le signal d'horloge dans lequel cet élément de pilotage est destiné à activer les premiers éléments d'alimentation et d'acquisition à une cadence imposée par l'horloge, l'horloge et l'élément de pilotage étant alimentés par une tension définie par la différence entre d'une part un potentiel intermédiaire fourni par un second élément d'alimentation, compris entre le potentiel de source et un potentiel de masse, et d'autre part le potentiel de masse.

Ainsi, l'horloge est avantageusement alimentée par le deuxième élément d'alimentation par une tension relativement limitée définie par la différence entre le potentiel intermédiaire et le potentiel de masse.

De plus, l'élément de pilotage permet d'activer et désactiver le premier élément d'alimentation de façon à limiter la consommation de courant, notamment en interrompant l'alimentation du premier élément d'acquisition lorsque ce dernier n'effectue pas d'acquisition.

La consommation de courant des éléments de la chaîne est donc limitée et ce sans nuire à la précision de la mesure des paramètres et à la sécurité électrique du véhicule automobile.

Un dispositif selon l'invention peut comporter en outre l'une ou les caractéristiques suivantes :
- la chaîne comprend un élément comparateur pour la comparaison d'une valeur du premier paramètre acquis par le premier élément d'acquisition avec un seuil prédéterminé, l'élément de pilotage gérant l'activation/la désactivation du premier élément d'alimentation en fonction d'une information fournie par l'élément comparateur ;
- l'élément comparateur est alimenté par une tension définie par la différence entre le potentiel de source et le potentiel supérieur à ce potentiel de source ;
- le premier paramètre est une intensité d'un courant circulant dans un circuit raccordé au potentiel de source, ce premier paramètre étant fourni par un shunt relié à ce circuit ;
- le premier élément d'alimentation forme un élévateur de tension raccordé au potentiel de source et alimenté par une tension définie par la différence entre le potentiel de source et le potentiel de masse ;
- le deuxième élément d'alimentation forme un régulateur d'une tension définie par la différence entre le potentiel de source et le potentiel de masse raccordé au potentiel de source et alimenté par une tension définie par une différence entre le potentiel de source et le potentiel de masse ;
- la chaîne comprend un second élément d'acquisition d'un second paramètre fourni par un pont diviseur de tension raccordé au potentiel de source, alimenté par une tension définie par la différence entre le potentiel de source et le potentiel supérieur à ce potentiel de source ;
- le second paramètre est une tension définie par la différence entre le potentiel de source et le potentiel de masse fournie par le pont diviseur de tension au second élément d'acquisition ;
- le second paramètre est une température fournie par le pont diviseur de tension au second élément d'alimentation, ce pont diviseur de tension comprenant au moins une thermistance ;
- la chaîne comprend un élément de communication avec un organe électrique extérieur à la chaîne, cet élément de communication étant alimenté par une tension définie par la différence entre le potentiel intermédiaire et le potentiel de masse ;
- l'élément de pilotage comprend un microcontrôleur ;
- la chaîne comprend de plus un élément d'adaptation, reliant :
   - d'une part, un premier ensemble d'éléments de la chaîne comprenant au moins le premier élément d'acquisition, chaque élément du premier ensemble étant alimenté par une tension définie par la différence entre le potentiel de source et le potentiel supérieur à ce potentiel de source, avec
   - d'autre part, un second ensemble d'éléments de la chaîne comprenant au moins l'élément de pilotage, chaque élément du second ensemble étant alimenté par une tension définie par la différence entre le potentiel intermédiaire et le potentiel de masse,
de façon à adapter un signal conditionné par un élément du premier ensemble, ayant pour potentiel de référence le potentiel de source à un potentiel de référence d'un élément du second ensemble ayant pour potentiel de référence le potentiel de masse et réciproquement.

L'invention sera mieux comprise à la lecture de la description qui va suivre, donnée uniquement à titre d'exemple et faite en se référant aux dessins dans lesquels :
- la figure 1 est un schéma d'un dispositif de mesure selon l'invention ;
- la figure 2 est un graphique représentant une courbe d'évolution d'un signal émis par une horloge du dispositif de la figure 1 en fonction du temps ;
- les figures 3 à 5 sont des graphiques représentant chacun une courbe d'évolution de l'état respectivement d'un premier élément d'alimentation, d'un premier élément d'acquisition et d'un élément comparateur du dispositif de la figure 1 en fonction du temps.

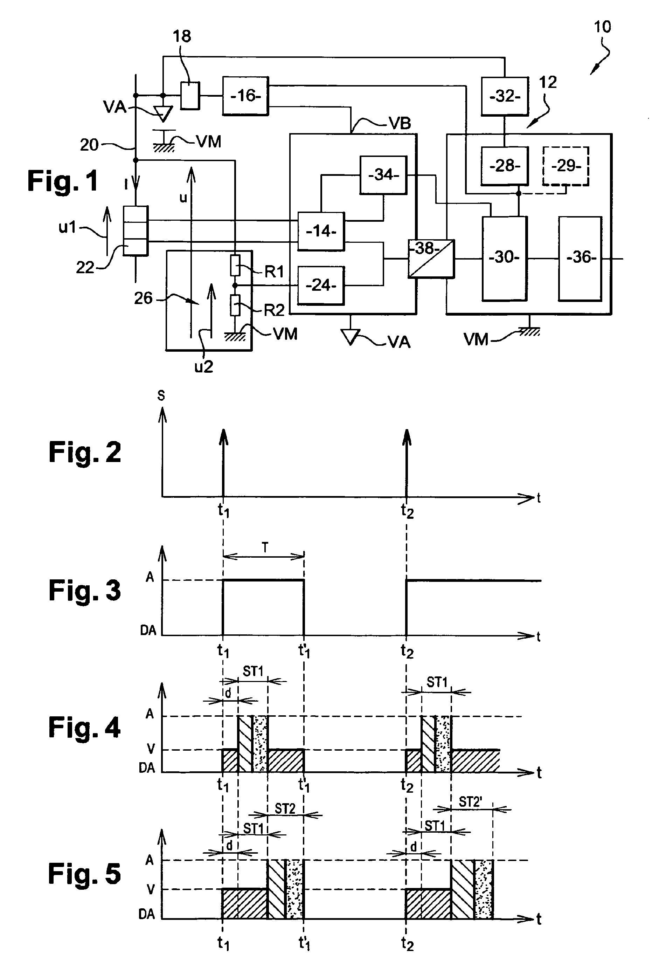

On a représenté sur la figure 1 un dispositif de mesure de paramètres selon l'invention désigné par la référence générale 10.

Plus particulièrement, ce dispositif est destiné à mesurer des paramètres d'une source d'alimentation électrique notamment une batterie de véhicule automobile (non représenté).

Le dispositif 10 comprend une chaîne 12 d'acquisition et de traitement de données.

En particulier, la chaîne 12 comprend un premier élément 14 d'acquisition d'un premier paramètre.

Ce premier élément d'acquisition 14 est alimenté par une tension définie par la différence entre un potentiel VA de source d'alimentation électrique et un potentiel VB supérieur à ce potentiel de source VA.

Dans l'exemple décrit, le potentiel de source VA est une borne positive de la batterie du véhicule automobile et a une valeur d'environ 12 volts.

Le potentiel VB supérieur à ce potentiel de source VA est fourni par un premier élément d'alimentation 16 formant élévateur de tension et a, par exemple, une valeur d'environ 17 volts. L'élévateur de tension 16 est par exemple du type à pompe de charge.

L'élévateur de tension 16 est alimenté par une tension définie par la différence entre le potentiel de source VA et un potentiel de masse VM.

Dans l'exemple décrit, le potentiel de masse VM est une borne négative de la batterie.

Par ailleurs, l'élévateur de tension 16 est relié au potentiel de source VA par l'intermédiaire d'un élément 18 de filtrage de tension de manière à protéger les éléments de la chaîne 12 de tensions trop élevées.

Le premier paramètre est une intensité I d'un courant circulant dans le circuit 20 relié à la borne positive de la batterie.

A cet effet, la chaîne 12 comprend un shunt 22 relié au circuit 20 et au premier élément d'acquisition 14. Le shunt 22 a par exemple une résistance de valeur 100 µΩ.

Ainsi, le premier élément d'acquisition 14 relève une tension U1 définie par la différence de potentiel aux bornes du shunt 22, cette tension U1 étant, de façon connue en soi, proportionnelle à l'intensité I à mesurer.

La chaîne 12 comprend encore un second élément 24 d'acquisition d'un second paramètre.

Dans cet exemple, le second élément d'acquisition 24 est alimenté par une tension définie par la différence entre le potentiel de source VA et le potentiel supérieur VB à ce potentiel de source VA.

Plus particulièrement, le second paramètre est une tension U définie par la différence entre le potentiel de source VA et le potentiel de masse VM et est fourni par un pont 26 diviseur de tension raccordé au potentiel de source VA.

Ainsi, de façon classique et comme illustré sur la figure 1, le pont diviseur de tension 26 comprend deux résistances R1 et R2.

Le deuxième élément d'acquisition 24 est destiné à relever la tension U2 définie par la différence de potentiel aux bornes de la résistance R2. Cette tension U2 est, de façon classique, proportionnelle à la tension U à mesurer.

Le second paramètre peut également être une température. Dans ce cas, le dispositif 10 peut également comporter un autre pont diviseur de tension (non représenté). Cet autre pont diviseur comprend, par exemple, une thermistance. Le second élément d'acquisition 24 est alors destiné à relever la tension définie par la différence de potentiel aux bornes de la thermistance de manière à obtenir une température.

Le dispositif 10 comprend encore une horloge 28. L'horloge 28 est destinée à cadencer un signal S (figure 2) d'activation, dit signal d'horloge, d'un élément de la chaîne 12.

Sur la figure 2, on a représenté seulement deux impulsions du signal S : une première impulsion à un temps t1 et une deuxième impulsion à un temps t2.

Conformément à l'invention, l'élément de la chaîne 12 activé par le signal d'horloge S est un élément de pilotage 30 de l'élévateur de tension 16 et du premier élément d'acquisition 14. De préférence, l'élément de pilotage 30 est un microcontrôleur.

En outre, l'horloge 28 et le microcontrôleur 30 sont alimentés par une tension définie par la différence entre d'une part un potentiel intermédiaire VC fourni par un second élément d'alimentation, compris entre le potentiel de source VA et un potentiel de masse VM, et d'autre part le potentiel de masse VM.

Le potentiel intermédiaire VC est fourni par un deuxième élément d'alimentation 32. De préférence, le deuxième élément d'alimentation 32 forme un régulateur d'une tension définie par la différence entre le potentiel de source VA et le potentiel de masse VM et alimenté par une tension définie par une différence entre le potentiel de source VA et le potentiel de masse VM.

Eventuellement, l'horloge 28 forme un élément intégré du microcontrôleur 30.

En particulier, le microcontrôleur 30 est susceptible d'adopter un état de veille coïncidant avec un état désactivé de l'élévateur de tension 16, et un état actif à la suite de son activation par le signal d'horloge S.

Plus précisément, dans son état actif, le microcontrôleur 30 est destiné à activer l'élévateur de tension 16 et le premier élément d'acquisition 14 à une cadence imposée par l'horloge 28.

Ainsi, en considérant la courbe d'évolution de l'état de l'élévateur de tension 16 en fonction du temps représentée sur la figure 3, on voit que l'élévateur de tension 16 est dans un état actif « A » pendant une période T suivant l'émission de la première impulsion (figure 2) et un état désactivé « DA » à partir de la fin de la période T, au temps t1', jusqu'à l'émission de l'impulsion suivante, au temps t2.

Par ailleurs, en considérant la courbe d'évolution de l'état du premier élément d'acquisition 14 en fonction du temps représentée sur la figure 4, on voit que le premier élément d'acquisition 14 est dans un état actif « A » pendant une sous-période ST1 suivant la première impulsion (figure 2) et dans un état désactivé « DA » entre les temps t1' et t2. Dans l'exemple décrit, la sous-période ST1 débute après une durée prédéterminée « d » après le temps t1, correspondant à la durée de démarrage du premier élément d'acquisition 14.

Au cours de cette sous-période ST1, le premier élément d'acquisition 14 est destiné à paramétrer et effectuer une acquisition d'une valeur de l'intensité du courant I.

La chaîne 12 comprend de plus un élément comparateur 34 pour la comparaison de la valeur de l'intensité acquise par le premier élément d'acquisition 14 avec un seuil prédéterminé.

L'élément comparateur 34 est alimenté par une tension définie par la différence entre le potentiel de source VA et le potentiel supérieur VB à ce potentiel de source.

Par ailleurs, l'élément comparateur 34 est destiné à fournir une information au microcontrôleur 30, cette information correspondant au résultat de la comparaison. Par exemple, l'information est fournie sous forme d'un signal de tension, dit signal d'information, conditionné par l'élément comparateur 34. Le signal d'information a pour potentiel de référence, le potentiel de source VA.

Ainsi, en considérant la courbe d'évolution de l'état de l'élément comparateur 34 en fonction du temps représentée sur la figure 5, on voit que l'élément comparateur 34 est dans un état actif « A » pendant une sous-période ST2, suivant la sous-période ST1 et dans un état désactivé « DA », par exemple, entre les temps t1' et t2.

Au cours de cette sous-période ST2, l'élément comparateur 34 est destiné à effectuer une comparaison de la valeur de l'intensité I du courant acquise avec le seuil prédéterminé et à conditionner le signal d'information, correspondant au résultat de la comparaison.

En particulier, à la fin de la sous-période ST2, le microcontrôleur 30 est destiné à piloter l'activation/la désactivation de l'élévateur de tension 16 en fonction de l'information fournie par l'élément comparateur 34.

De façon avantageuse, le microcontrôleur 30 est destiné à maintenir l'activation de l'élévateur de tension 16 tant que la valeur acquise est supérieure au seuil et à piloter la désactivation de l'élévateur 16 lorsque la valeur est inférieure au seuil.

On appellera « mode réveil », l'état du microcontrôleur 30 dans lequel il est destiné à maintenir l'activation de l'élévateur de tension 16.

On notera que, au cours de la période T, les éléments 14 et 24 sont alimentés continûment par l'élévateur de tension 16 et par conséquent sont maintenus en état de veille « V » en dehors de leurs sous-périodes d'activation respectives ST1 et ST2. En particulier, les éléments 14 et 24 ont des consommations d'intensité de courant non nulles en état de veille « V ».

La chaîne 12 comprend encore un élément 36 de communication avec un organe électrique (non représenté) extérieur à la chaîne 12, cet élément de communication 36 étant alimenté par une tension définie par la différence entre le potentiel intermédiaire VC et le potentiel de masse VM.

Les premier 14 et deuxième 24 éléments d'acquisition ainsi que l'élément comparateur 34, étant alimentés par une tension définie par une différence entre le potentiel de source VA et le potentiel supérieur VB au potentiel de source, forment un premier ensemble E1 d'éléments de la chaîne 12.

En particulier, les éléments du premier ensemble E1 sont reliés entre eux de façon à échanger entre eux des signaux de tension ayant pour référence le potentiel de source VA.

Le microcontrôleur 30, l'horloge 28 et l'élément de communication 36, étant alimentés par une tension définie par une différence entre le potentiel intermédiaire VC et le potentiel de masse VM, forment un second ensemble E2 d'éléments de la chaîne 12.

En particulier, les éléments du second ensemble E2 sont reliés entre eux de façon à échanger entre eux des signaux de tension ayant pour référence le potentiel de masse VM.

Par ailleurs, afin de permettre l'échange de signaux entre les éléments du premier ensemble E1 et les éléments du second ensemble E2, la chaîne 12 comprend avantageusement un élément d'adaptation 38 reliant entre eux les premier E1 et second E2 ensembles.

De façon avantageuse, l'élément d'adaptation 38 permet d'adapter un signal conditionné par un élément du premier ensemble E1, ayant pour potentiel de référence le potentiel de source VA à un potentiel de référence d'un élément du second ensemble E2 ayant pour potentiel de référence le potentiel de masse VM et réciproquement.

On va maintenir décrire les principaux aspects du fonctionnement du dispositif liés à l'invention.

On considère initialement le moteur du véhicule automobile à l'arrêt (véhicule en stationnement). Dans ce cas, la consommation du courant de la batterie du véhicule automobile est relativement faible car n'alimentant que des organes électriques du véhicule automobile en état de veille, et l'intensité du courant 1 circulant dans le circuit 20 est inférieure au seuil prédéterminé.

En particulier, le microcontrôleur 30 est en état de veille et l'élévateur de tension 16 est désactivé (figure 2, « DA »).

Au temps t1, le microcontrôleur 30 est activé par la première impulsion du signal d'horloge S. Le microcontrôleur 30 active alors les premiers éléments d'acquisition 14 et d'alimentation 16.

En particulier, le premier élément d'acquisition 14 est dans l'état actif « A » pendant une sous-période ST1.

A la fin de la sous-période ST1, le premier élément d'acquisition 14 conditionne un signal de tension, correspondant aux données de l'intensité du courant, et le transmet à l'élément comparateur 34. Ce signal a pour effet l'activation de l'élément comparateur 34.

Ainsi, l'élément comparateur 34 est dans l'état actif « A » pendant une sous-période ST2. A la fin de cette sous-période ST2, l'élément comparateur 34 conditionne un signal d'information et le transmet au microcontrôleur 30.

Comme l'intensité I du courant est inférieure au seuil, le microcontrôleur 30 désactivé l'élévateur de tension 16 et se met en état de veille au temps t1'.

On considère qu'entre les temps t1' et t2, le moteur tourne (démarrage ou roulage du véhicule) et certains organes électriques du véhicule requerrant un courant d'alimentation d'intensité élevée sont activés. L'intensité du courant I franchit alors à la hausse le seuil prédéterminé.

Eventuellement, le franchissement à la hausse du seuil par l'intensité du courant peut se produire lorsque le moteur du véhicule est à l'arrêt, par exemple en cas de dysfonctionnement d'un organe électrique dont la consommation de courant devient anormalement élevée.

Au temps t2, le microcontrôleur 30, en état de veille, est activé par la deuxième impulsion du signal d'horloge S et active l'élévateur de tension 16 ainsi que le premier élément d'acquisition 14.

A la fin de la sous-période ST2, l'élément comparateur 34 fournit alors le résultat de la comparaison de la valeur de l'intensité acquise avec le seuil.

Comme l'intensité acquise est supérieure au seuil, le microcontrôleur 30 passe dans le « mode réveil » et maintient l'élévateur de tension 16 dans son état actif « A ».

Dans ce « mode réveil », le microcontrôleur 30 est destiné à activer les premier 14 et deuxième 24 éléments d'acquisition pour l'acquisition des premier (intensité I) et deuxième (température, tension U) paramètres à la cadence imposée par l'horloge 28. Le microcontrôleur 30 effectue alors un traitement des données fournies par les deux éléments d'acquisition 14 et 24.

Eventuellement, le microcontrôleur 30, dans le « mode réveil », peut contrôler la cadence du signal d'horloge émis par l'horloge 28, de façon par exemple à augmenter la fréquence des impulsions du signal.

Ainsi, dans ce « mode réveil », la fréquence des acquisitions des paramètres est plus élevée. L'augmentation de la fréquence des acquisitions permet ainsi de déterminer, dans un délai le plus court possible, un dysfonctionnement éventuel d'un organe électrique du véhicule.

En variante, dans le « mode réveil », le dispositif 10 comprend une autre horloge 29 représentée sur la figure 1 en traits discontinus, dite « haute fréquence » destinée à cadencer le signal d'activation du premier élément d'acquisition 14 à une cadence supérieure à la cadence imposée par l'horloge 28, dite par opposition « basse fréquence ». Dans ce cas, l'horloge 28 est désactivée par le microcontrôleur 30.

Par exemple, l'horloge « haute fréquence » 29 forme un élément intégré du microcontrôleur 30.

L'activation de l'élévateur 16 est maintenue jusqu'au franchissement à la baisse du seuil par la valeur de l'intensité acquise.

Ainsi, lorsque le moteur est à l'arrêt, le dispositif selon l'invention permet de réaliser des mesures précises de l'intensité du courant à une cadence imposée par l'horloge 28, tout en limitant la consommation de courant du dispositif.

## Revendications

1. Dispositif (10) de mesure de paramètres, du type comprenant une chaîne (12) d'acquisition et de traitement de données comportant :
- un premier élément (14) d'acquisition d'un premier paramètre, alimenté par une tension définie par une différence entre un potentiel (VA) de source d'alimentation électrique et un potentiel (VB) supérieur à ce potentiel de source (VA), le potentiel supérieur (VB) étant fourni par un premier élément d'alimentation (16),
- une horloge (28) destinée à cadencer un signal d'activation d'un élément de la chaîne, dit signal d'horloge (S),
**caractérisé en ce que** l'élément activé par le signal d'horloge (S) est un élément (30) de pilotage des premiers éléments d'alimentation (16) et d'acquisition (14), susceptible d'adopter un état de veille coïncidant avec un état désactivé du premier élément d'alimentation (16), et un état actif à la suite de son activation par le signal d'horloge (S) dans lequel cet élément de pilotage (30) est destiné à activer les premiers éléments d'alimentation (16) et d'acquisition (14) à une cadence imposée par l'horloge (28), l'horloge (28) et l'élément de pilotage (30) étant alimentés par une tension définie par la différence entre d'une part un potentiel intermédiaire (VC) fourni par un second élément d'alimentation (32), compris entre le potentiel de source (VA) et un potentiel de masse (VM), et d'autre part le potentiel de masse (VM).

2. Dispositif (10) de mesure selon la revendication 1, dans lequel la chaîne (12) comprend un élément (34) comparateur pour la comparaison d'une valeur du premier paramètre acquis par le premier élément d'acquisition (14) avec un seuil prédéterminé, l'élément de pilotage (30) gérant l'activation/la désactivation du premier élément d'alimentation (16) en fonction d'une information fournie par l'élément comparateur (34).

3. Dispositif (10) de mesure selon la revendication 2, dans lequel l'élément comparateur (34) est alimenté par une tension définie par la différence entre le potentiel de source (VA) et le potentiel supérieur (VB) à ce potentiel de source.

4. Dispositif (10) de mesure selon l'une quelconque des revendications 1 à 3, dans lequel le premier paramètre est une intensité d'un courant (I) circulant dans un circuit (20) raccordé au potentiel de source (VA), ce premier paramètre étant fourni par un shunt (22) relié à ce circuit (20).

5. Dispositif (10) selon l'une quelconque des revendications 1 à 4, dans lequel le premier élément d'alimentation (16) forme un élévateur de tension raccordé au potentiel de source (VA) et alimenté par une tension définie par la différence entre le potentiel de source (VA) et le potentiel de masse (VM).

6. Dispositif (10) de mesure selon l'une quelconque des revendications 1 à 5, dans lequel le deuxième élément d'alimentation (32) forme un régulateur d'une tension définie par la différence entre le potentiel de source (VA) et le potentiel de masse (VM) raccordé au potentiel de source (VA) et alimenté par une tension définie par une différence entre le potentiel de source (VA) et le potentiel de masse (VM).

7. Dispositif (10) de mesure selon l'une quelconque des revendications 1 à 6, dans lequel la chaîne (12) comprend un second élément d'acquisition (24) d'un second paramètre fourni par un pont diviseur de tension raccordé au potentiel de source (VA), alimenté par une tension définie par la différence entre le potentiel de source (VA) et le potentiel supérieur (VB) à ce potentiel de source.

8. Dispositif (10) de mesure selon la revendication 7, dans lequel le second paramètre est une tension définie par la différence entre le potentiel de source (VA) et le potentiel de masse (VM) fournie par le pont diviseur de tension au second élément d'acquisition (24).

9. Dispositif (10) de mesure selon la revendication 7, dans lequel le second paramètre est une température fournie par le pont diviseur de tension au second élément d'acquisition (24), ce pont diviseur de tension comprenant au moins une thermistance.

10. Dispositif (10) de mesure selon l'une quelconque des revendications 1 à 9, dans lequel la chaîne (12) comprend un élément de communication (36) avec un organe électrique extérieur à la chaîne, cet élément de communication (36) étant alimenté par une tension définie par la différence entre le potentiel intermédiaire (VC) et le potentiel de masse (VM).

11. Dispositif (10) de mesure selon l'une quelconque des revendications 1 à 10, dans lequel l'élément de pilotage (30) comprend un microcontrôleur.

12. Dispositif (10) selon l'une quelconque des revendications 1 à 11, dans lequel la chaîne (12) comprend de plus un élément d'adaptation (38), reliant :
- d'une part, un premier ensemble d'éléments de la chaîne (12) comprenant au moins le premier élément d'acquisition (14), chaque élément du premier ensemble étant alimenté par une tension définie par la différence entre le potentiel de source (VA) et le potentiel supérieur (VB) à ce potentiel de source, avec
- d'autre part, un second ensemble d'éléments de la chaîne (12) comprenant au moins l'élément de pilotage (30), chaque élément du second ensemble étant alimenté par une tension définie par la différence entre le potentiel intermédiaire (VC) et le potentiel de masse (VM),
de façon à adapter un signal conditionné par un élément du premier ensemble, ayant pour potentiel de référence le potentiel de source (VA) à un potentiel de référence d'un élément du second ensemble ayant pour potentiel de référence le potentiel de masse (VM) et réciproquement.

## Claims

1. Device (10) for measuring parameters, of the type including a data acquisition and processing system (12) including:
- a first element (14) for acquiring a first parameter, fed with a voltage defined by a difference between an electrical power supply potential (VA) and a potential (VB) higher than this supply potential (VA), the higher potential (VB) being supplied by a first power supply element (16),
- a clock (28) for clocking a signal for activating an element of the system, called the clock signal (S), **characterized in that** the element activated by the clock signal (S) is an element (30) for controlling the first power supply element (16) and the first acquisitions element (14) adapted to adopt a standby state coinciding with a deactivated state of the first power supply element (16) and an active state after its activation by the clock signal (S) in which this control element (30) is intended to activate the first power supply element (16) and the first acquisition element (14) at a rate imposed by the clock (28), the clock (28) and the control element (30) being fed with a voltage defined by the difference between on the one hand an intermediate potential (VC) supplied by a second power supply element (32), between the supply potential (VA) and an earth potential (VM), and on the other hand the earth potential (VM).

2. Measuring device (10) according to claim 1, wherein the system (12) includes a comparator element (34) for comparing a value of the first parameter acquired by the first acquisition element (14) with a predetermined threshold, the control element (30) managing activation/deactivation of the first power supply element (16) as a function of information supplied by the comparator element (34).

3. Measuring device (10) according to claim 2, wherein the comparator element (34) is fed with a voltage defined by the difference between the supply potential (VA) and the potential (VB) higher than this supply potential.

4. Measuring device (10) according to any one of claims 1 to 3, wherein the first parameter is an intensity of a current (I) flowing in a circuit (20) connected to the supply potential (VA), this first parameter being supplied by a shunt (22) connected to this circuit (20).

5. Device (10) according to any one of claims 1 to 4, wherein the first power supply element (16) forms a voltage booster connected to the supply potential (VA) and fed with a voltage defined by the difference between the supply potential (VA) and the earth potential (VM).

6. Measuring device (10) according to any one of claims 1 to 5, wherein the second power supply element (32) forms a regulator for a voltage defined by the difference between the supply potential (VA) and the earth potential (VM) connected to the supply potential (VA) and fed with a voltage defined by a difference between the supply potential (VA) and the earth potential (VM).

7. Measuring device (10) according to any one of claims 1 to 6, wherein the system (12) includes a second acquisition element (24) for acquiring a second parameter supplied by a voltage divider bridge connected to the supply potential (VA), fed with a voltage defined by the difference between the supply potential (VA) and the potential (VB) higher than this supply potential.

8. Measuring device (10) according to claim 7, wherein the second parameter is a voltage defined by the difference between the supply potential (VA) and the earth potential (VM) supplied by the voltage divider bridge to the second acquisition element (24).

9. Measuring device (10) according to claim 7, wherein the second parameter is a temperature supplied by the voltage divider bridge to the second acquisition element (24), this voltage divider bridge including at least one thermistor.

10. Measuring device (10) according to any one of claims 1 to 9, wherein the system (12) includes a communication element (36) for communication with an electrical unit external to the system, this communication element (36) being fed with a voltage defined by the difference between the intermediate potential (VC) and the earth potential (VM).

11. Measuring device (10) according to any one of claims 1 to 10, wherein the control element (30) includes a microcontroller.

12. Device (10) according to any one of claims 1 to 11, wherein the system (12) further includes an adapter element (38) connecting:
- on the one hand, a first set of elements of the system (12) including at least the first acquisition element (14), each element of the first set being fed with a voltage defined by the difference between the supply potential (VA) and the potential (VB) higher than this supply potential, to
- on the other hand, a second set of elements of the system (12) including at least the control element (30), each element of the second set being fed with a voltage defined by the difference between the intermediate potential (VC) and the earth potential (VM),
so as to adapt a signal conditioned by an element of the first set, having for its reference potential the supply potential (VA) to a reference potential of an element of the second set having for its reference potential the earth potential (VM) and vice versa.

## Patentansprüche

1. Vorrichtung (10) zur Messung von Parametern, von der Art, die eine Erfassungs- und Verarbeitungskette (12) von Daten enthält, die aufweist:
- ein erstes Element (14) zur Erfassung eines ersten Parameters, das mit einer Spannung versorgt wird, die durch eine Differenz zwischen einem Potential (VA) einer Stromversorgungsquelle und einem Potential (VB) höher als dieses Quellenpotential (VA) definiert wird, wobei das höhere Potential (VB) von einem ersten Versorgungselement (16) geliefert wird,
- einen Taktgeber (28), der dazu bestimmt ist, ein Aktivierungssignal eines Elements der Kette zu takten, Taktsignal (S) genannt,
**dadurch gekennzeichnet, dass** das vom Taktsignal (S) aktivierte Element ein Steuerelement (30) der ersten Versorgungs- (16) und Erfassungselemente (14) ist, das einen Standby-Zustand, der mit einem deaktivierten Zustand des ersten Versorgungselements (16) zusammenfällt, und einen aktiven Zustand nach seiner Aktivierung durch das Taktsignal (S) annehmen kann, in dem dieses Steuerelement (30) dazu bestimmt ist, die ersten Versorgungs- (16) und Erfassungselemente (14) mit einem Takt zu aktivieren, der vom Taktgeber (28) vorgegeben wird, wobei der Taktgeber (28) und das Steuerelement (30) mit einer Spannung versorgt werden, die durch die Differenz zwischen einerseits einem von einem zweiten Versorgungselement (32) gelieferten Zwischenpotential (VC), das zwischen dem Quellenpotential (VA) und einem Massepotential (VM) liegt, und andererseits dem Massepotential (VM) definiert wird.

2. Messvorrichtung (10) nach Anspruch 1, wobei die Kette (12) ein Komparatorelement (34) für den Vergleich eines Werts des vom ersten Erfassungselement (14) erfassten ersten Parameters mit einer vorbestimmten Schwelle enthält, wobei das Steuerelement (30) die Aktivierung/Deaktivierung des ersten Versorgungselements (16) abhängig von einer vom Komparatorelement (34) gelieferten Information verwaltet.

3. Messvorrichtung (10) nach Anspruch 2, wobei das Komparatorelement (34) mit einer Spannung versorgt wird, die durch die Differenz zwischen dem Quellenpotential (VA) und dem Potential (VB) definiert wird, das höher ist als dieses Quellenpotential.

4. Messvorrichtung (10) nach einem der Ansprüche 1 bis 3, wobei der erste Parameter eine Stärke eines Stroms (I) ist, der in einer mit dem Quellenpotential (VA) verbundenen Schaltung (20) fließt, wobei dieser erste Parameter von einem mit dieser Schaltung (20) verbundenen Shunt (22) geliefert wird.

5. Vorrichtung (10) nach einem der Ansprüche 1 bis 4, wobei das erste Versorgungselement (16) einen Spannungserhöher formt, der mit dem Quellenpotential (VA) verbunden ist und mit einer Spannung versorgt wird, die durch die Differenz zwischen dem Quellenpotential (VA) und dem Massepotential (VM) definiert wird.

6. Messvorrichtung (10) nach einem der Ansprüche 1 bis 5, wobei das zweite Versorgungselement (32) einen Regler einer durch die Differenz zwischen dem Quellenpotential (VA) und dem Massepotential (VM) definierten Spannung formt, der mit dem Quellenpotential (VA) verbunden ist und mit einer Spannung versorgt wird, die durch eine Differenz zwischen dem Quellenpotential (VA) und dem Massepotential (VM) definiert wird.

7. Messvorrichtung (10) nach einem der Ansprüche 1 bis 6, wobei die Kette (12) ein zweites Erfassungselement (24) eines zweiten Parameters enthält, der von einer mit dem Quellenpotential (VA) verbundenen Spannungsteilerbrücke geliefert wird, das mit einer Spannung versorgt wird, die durch die Differenz zwischen dem Quellenpotential (VA) und dem Potential (VB) definiert wird, das höher ist als dieses Quellenpotential.

8. Messvorrichtung (10) nach Anspruch 7, wobei der zweite Parameter eine durch die Differenz zwischen dem Quellenpotential (VA) und dem Massepotential (VM) definierte Spannung ist, die von der Spannungsteilerbrücke an das zweite Erfassungselement (24) geliefert wird.

9. Messvorrichtung (10) nach Anspruch 7, wobei der zweite Parameter eine Temperatur ist, die von der Spannungsteilerbrücke an das zweite Erfassungselement (24) geliefert wird, wobei dieser Spannungsteiler mindestens einen Thermistor enthält.

10. Messvorrichtung (10) nach einem der Ansprüche 1 bis 9, wobei die Kette (12) ein Kommunikationselement (36) mit einem elektrischen Organ außerhalb der Kette enthält, wobei dieses Kommunikationselement (36) mit einer durch die Differenz zwischen dem Zwischenpotential (VC) und dem Massepotential (VM) definierten Spannung versorgt wird.

11. Messvorrichtung (10) nach einem der Ansprüche 1 bis 10, wobei das Steuerelement (30) einen Mikrocontroller enthält.

12. Vorrichtung (10) nach einem der Ansprüche 1 bis 11, wobei die Kette (12) außerdem ein Anpassungselement (38) enthält, das verbindet:
- einerseits eine erste Einheit von Elementen der Kette (12), die mindestens das erste Erfassungselement (14) enthält, wobei jedes Element der ersten Einheit mit einer durch die Differenz zwischen dem Quellenpotential (VA) und dem höheren Potential (VB) als dieses Quellenpotential definierten Spannung versorgt wird, mit
- andererseits einer zweiten Einheit von Elementen der Kette (12), die mindestens das Steuerelement (30) enthält, wobei jedes Element der zweiten Einheit mit einer durch die Differenz zwischen dem Zwischenpotential (VC) und dem Massepotential (VM) definierten Spannung versorgt wird,
um ein von einem Element der ersten Einheit bedingtes Signal, das als Bezugspotential das Quellenpotential (VA) hat, an ein Bezugspotential eines Elements der zweiten Einheit anzupassen, das als Bezugspotential das Massepotential (VM) hat und umgekehrt.
